# EUROPÄISCHE PATENTSCHRIFT

(11) **EP 4 373 227 B1**
(45) Veröffentlichungstag und Bekanntmachung des Hinweises auf die Patenterteilung: **08.04.2026**
(21) Anmeldenummer: 22208536.7
(22) Anmeldetag: 21.11.2022
(51) Int. Cl.: H05K 7/14

(54) **AUTOMATISIERUNGSBAUGRUPPE MIT EINEM ADAPTER**
AUTOMATION ASSEMBLY WITH AN ADAPTER
MODULE D'AUTOMATISATION DOTÉ D'UN ADAPTATEUR

(43) Veröffentlichungstag der Anmeldung: 22.05.2024
(73) Patentinhaber: Siemens Aktiengesellschaft, 80333 München (DE)
(72) Erfinder: Bergmann, Martin, 92253 Schnaittenbach (DE); Schmidt, Alexander, 65189 Wiesbaden (DE); Stein, Ulf, 92421 Schwandorf (DE)
(74) Vertreter: Siemens Patent Attorneys

(56) Entgegenhaltungen:
- EP-A1- 3 582 596

## Beschreibung

Die Erfindung betrifft eine Automatisierungsbaugruppe mit einem Gehäuse und einem Adapter, wobei das Gehäuse eine Rückseite, eine Vorderseite, eine Unterseite, eine Oberseite, eine linke Seite und eine rechte Seite aufweist, in dem Gehäuse ist eine erste Leiterplatte parallel zwischen der linken Seite und der rechten Seite des Gehäuses angeordnet, die Unterseite und die Oberseite sind zumindest teilweise als ein Lüftungsgitter ausgestaltet, um eine Konvektionskühlung im Inneren des Gehäuses zu ermöglichen.

Aus den folgenden Patentschriften bzw. Offenlegungsschriften sind Automatisierungskomponenten mit Gehäusen und Lüftungsgittern bereits bekannt, die EP 2 906 030 B1 beschreibt eine elektronische Baugruppe mit einer elektrisch leitfähigen Verbindung. Die EP 2 624 378 B1 beschreibt eine Ein-/Ausgabebaugruppe der industriellen Automatisierungstechnik. Die EP 2 654 317 B1 zeigt eine Ein-/Ausgabebaugruppe mit einem Anzeigeelement. Die EP 2 683 227 B1 zeigt ein Elektronikmodul zum Einstecken in eine Trägereinheit. Die EP 2 728 984 A1 offenbart ein Gehäuse mit einem ersten Gehäuseteil und mit einem zweiten Gehäuseteil mit einem Zapfengelenk. In der EP 3 582 596 A1 ist ein Gehäuse eines elektronischen Geräts offenbart, für eine sichere und einfache Codierung des Gehäuses zu einem Steckverbinder ist ein Codierstift im Gehäuse vorgesehen.

Es ist Aufgabe der vorliegenden Erfindung den Automatisierungsbaugruppen nach dem Stand der Technik eine Wartungs- und Diagnoseschnittstelle zur Verfügung zu stellen, ohne das äußere Erscheinungsbild der Baugruppe zu ändern.

Die Aufgabe wird dadurch gelöst, dass für die eingangs genannte Automatisierungsbaugruppe auf der ersten Leiterplatte in unmittelbarer Nähe zu der Oberseite ein erster Steckverbinder angeordnet ist, weiterhin ist auf der Oberseite lösbar der Adapter angeordnet, der Adapter weist einen zweiten Steckverbinder auf und ist als ein Kodier-Element derart ausgestaltet, dass der Adapter Zapfen aufweist, welche derart angeordnet sind, dass sie bei einem Steckvorgang des zweiten Steckverbinders in dem ersten Steckverbinder durch Öffnungen des Lüftungsgitters passen und somit ein Steckvorgang des zweiten Steckverbinders in den ersten Steckverbinder möglich ist, bei dem Adapter sind weiterhin die Zapfen derart ausgestaltet, dass sie durch ihre Formgebung exakt in das vorhandene Lüftungsgitter passen. Hierdurch ist ein Verdrehschutz und die richtige Position gewährleistet.

Der nun vorliegende Adapter für die Baugruppe verfügt über Dome und Zapfen, die zusätzlich zur Kodierung auch eine Führung beim Einstecken in die Automatisierungsbaugruppe übernehmen. Des Weiteren bilden die Dome und Zapfen einen Schutz für die Kontakte der Steckverbinder. Für eine Anordnung der Dome und Zapfen ergeben sich vielfältige Möglichkeiten, um den Adapter je nach Funktion zu einem zugehörigen Automatisierungsgerät auszulegen. Mit einer unterschiedlichen Anordnung der Dome und Zapfen wird ein Einstecken in die Automatisierungsbaugruppe zugelassen oder blockiert. Automatisierungsbaugruppen können sein Controller, CPU's, Kommunikationsbaugruppen, Ein-/Ausgabebaugruppen, Regelbaugruppen, fehlersichere Baugruppen (F-Baugruppen), welche in der Regel alle für einen installierbaren modularen Stationsaufbau, insbesondere für einen dezentralen Aufbau, ausgelegt sind.

Mit Vorteil ist der erste Steckverbinder auf der ersten Leiterplatte als eine Wartungs- und Diagnoseschnittstelle ausgestaltet. Diese Schnittstelle ist im Gerät verborgen angebracht und somit gegen ungewollten Zugriff geschützt. Mit Vorteil ist nun bei Kenntnis das sich unter dem Lüftungsgitter sich eine Schnittstelle befindet die Erreichbarkeit einer Wartungs- und Diagnoseschnittstelle, z.B. für eine Debug-Funktion erfüllt. Insbesondere im Hinblick auf sicherheitstechnische Anlagen befindet sich diese Schnittstelle im Gerät verborgen.

Bei sicherheitsgerichteten Automatisierungsbaugruppen steht der erste Steckverbinder mit Teilen der Baugruppe in Verbindung, welche für einen sicherheitsrelevanten Betrieb ausgelegt sind, und der Adapter mit dem Kodier-Element bildet eine sicherheitsrelevante Kodierung, welche letztendlich einen Zugriff auf relevante Betriebsmittel durch ein Kontaktieren der beiden Steckverbinder zulässt oder durch ein Verhindern einer Kontaktierung der beiden Steckverbinder den Zugriff nicht zulässt. Das bietet den Vorteil, dass Module, welche in F-Technik ausgestaltet sind, nur für bestimmte Baugruppen über die Diagnoseschnittstelle ankoppelbar sind.

Weiterhin ist der erste Steckverbinder als eine Buchse und der zweite Steckverbinder mit zu beiden Seiten herausragenden Kontaktelementen ausgestaltet.

Zur Realisierung von von außen programmierbaren Sonderfunktionen ist im zweiten Steckverbinder zumindest eine lösbare Kontaktbrücke angeordnet und die Baugruppe ist ausgestaltet, eine gesteckte Kontaktbrücke zu erkennen.

Diese Kontaktbrücken sind als sogenannte "Jumper-Kontaktbrücken" ausgestaltet und können zwei Kontakte elektrisch Verbinden/Brücken.

Die Zapfen sind derart ausgestaltet, dass durch ihre Länge in Kombination eines Gegenstücks im Inneren des Gehäuses der Adapter passt oder blockiert wird.

In einer weiteren Verbesserung weist der Adapter einen Kragen um den zweiten Steckverbinder mit den herausragenden Kontaktelementen auf, und der Kragen ist mit einer Aussparung für eine Kodierung mit einem Gegenstück ausgestaltet.

Um den entsprechenden Adapter augenscheinlich und auf Anhieb leicht zu unterscheiden, wäre eine farbliche Differenzierung, eine Beschriftung oder ein anderes, gut erkennbares Kennzeichen möglich. Der Adapter weist hierzu eine Lichtquelle als erkennbares Kennzeichen auf, welches einen Anlagenbetreiber darauf aufmerksam macht, dass der Adapter gesteckt ist.

Für eine modulare Aufbautechnik ist bei der Automatisierungsbaugruppe die Rückseite ausgestaltet für eine lösbare Montage an einem Baugruppenträger.

Die Zeichnung zeigt ein Ausführungsbeispiel der Erfindung, dabei zeigt die
- FIG 1: eine Automatisierungsbaugruppe in einer dreidimensionalen Ansicht,
- FIG 2: einen Adapter,
- FIG 3: eine aufgeschnittene Darstellung der Automatisierungsbaugruppe mit Sicht auf den Adapter und der ersten Leiterplatte,
- FIG 4: den Adapter aus FIG 2 in einer gedrehten Ansicht und
- FIG 5: eine Detaildarstellung des Adapters mit Blick auf einen Kragen rund um einen Steckverbinder.

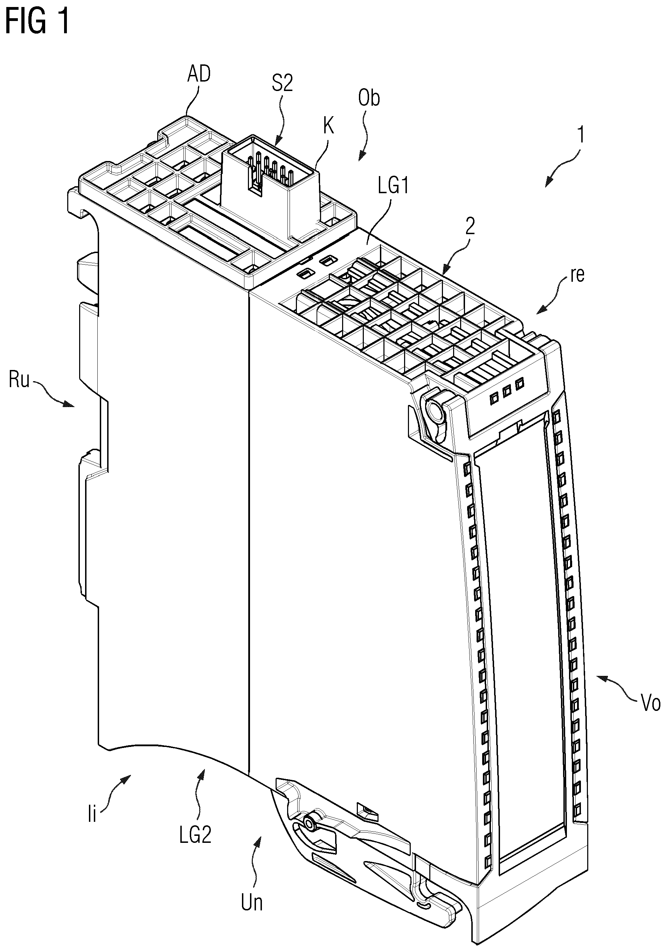

In FIG 1 ist eine Automatisierungsbaugruppe 1 mit einem Gehäuse 2 dargestellt. Das Gehäuse 2 weist eine Rückseite Ru, eine Vorderseite Vo, eine Unterseite Un, eine Oberseite Ob, eine linke Seite li und eine rechte Seite re auf. In dem Gehäuse 2 ist eine erste Leiterplatte LG1 parallel zwischen der linken Seite li und der rechten Seite re des Gehäuses 2 angeordnet. Die Unterseite Un und die Oberseite Ob sind zumindest teilweise als ein erstes Lüftungsgitter LG1 und ein zweites Lüftungsgitter LG2 ausgestaltet, um eine Konvektionskühlung im Inneren des Gehäuses 2 zu ermöglichen.

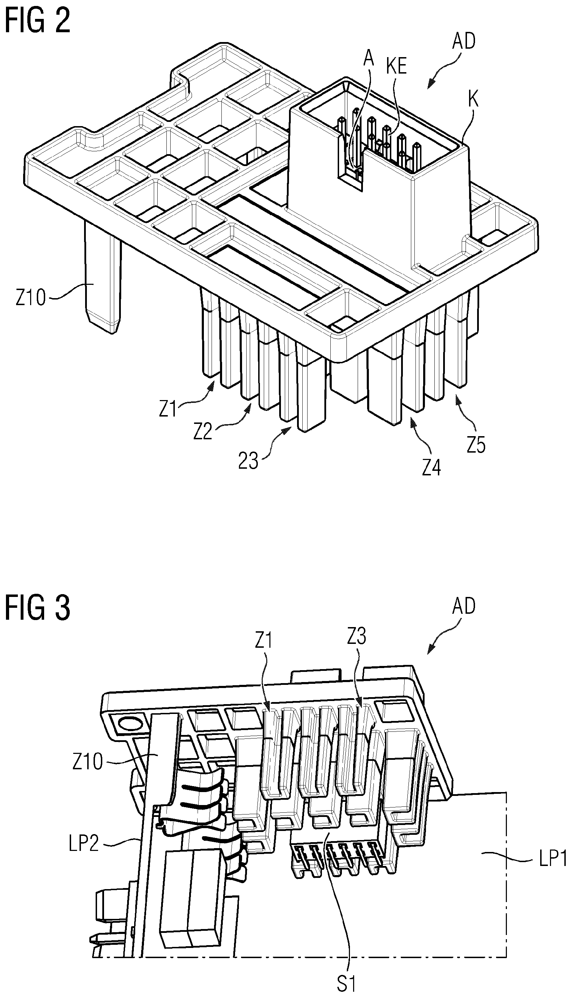

Auf der ersten Leiterplatte LP1 (siehe FIG 3) ist in unmittelbarer Nähe zu der Oberseite Ob ein erster Steckverbinder S1 angeordnet. Auf der Oberseite Ob ist lösbar ein Adapter AD angeordnet. Der Adapter AD weist einen zweiten Steckverbinder S2 auf und ist als ein Kodier-Element derart ausgestaltet, dass der Adapter AD Zapfen Z1,...,Z15 aufweist. Diese Zapfen Z1,...,Z15 sind derart angeordnet, dass sie bei einem Steckvorgang des zweiten Steckverbinders S2 in den ersten Steckverbinder S1 durch Öffnungen des Lüftungsgitters durch Öffnungen des ersten Lüftungsgitters LG1 passen und somit ein Steckvorgang des zweiten Steckverbinders S2 in den ersten Steckverbinder S1 möglich ist.

Die FIG 2 zeigt den Adapter AD in einer dreidimensionalen Ansicht um den zweiten Steckverbinder S2 ist ein Kragen K mit einer Ausnehmung A angeordnet. An einer Unterseite Un des Adapters AD befinden sich durchgezählt entgegen dem Uhrzeigersinn die Zapfen Z1,...,Z15.

Die FIG 3 zeigt den Adapter AD, wie er im gesteckten Zustand mit den ersten Steckverbinder auf der ersten Leiterplatte LP1 aufliegt. Ein zehnter Zapfen Z10 und ein neunter Zapfen Z9 sind derart ausgestaltet, dass durch ihre Länge in Kombination eines Gegenstücks, nämlich einer zweiten Leiterplatte LP2 im Inneren des Gehäuses 2 der Adapter AD auf einer entsprechenden Tiefe blockiert wird.

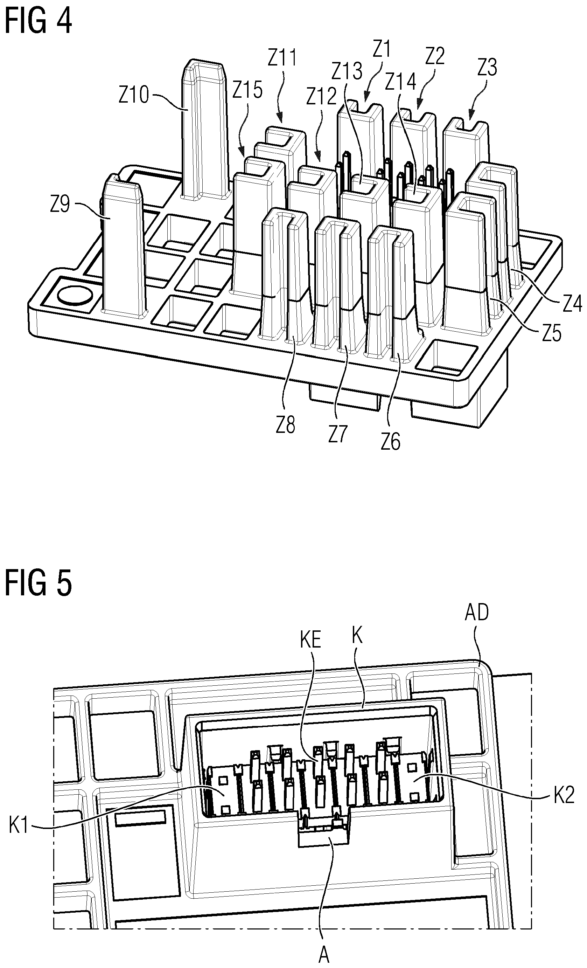

Die FIG 4 zeigt den mit FIG 2 beschriebenen Adapter AD mit Sicht auf die Zapfen Z1,...,Z15.

Die FIG 5 zeigt eine Detailansicht des Adapters AD mit Fokus auf den Kragen K. Der zweite Steckverbinder S2 zeigt die Kontaktelemente KE, wie sie nach außen ragen. Linksseitig von dem zweiten Steckverbinder S2 ist eine erste Kontaktbrücke K1 und rechtsseitig von dem zweiten Steckverbinder S2 ist eine zweite Kontaktbrücke K2 angeordnet. Die Baugruppe ist dabei derart ausgestaltet, dass sie eine gesteckte Kontaktbrücke K1,K2 im zweiten Steckverbinder S2 erkennen und für Spezialfunktionen auswerten kann.

## Patentansprüche

1. Automatisierungsbaugruppe (1) mit einem Gehäuse (2), wobei das Gehäuse (2) eine Rückseite (Ru),
eine Vorderseite (Vo),
eine Unterseite (Un),
eine Oberseite (Ob),
eine linke Seite (li) und
eine rechte Seite (re) aufweist,
in dem Gehäuse (2) ist eine erste Leiterplatte (LP1) parallel zwischen der linken Seite (li) und der rechten Seite (re) des Gehäuses (2) angeordnet,
die Unterseite (Un) und die Oberseite (Ob) sind zumindest teilweise als ein Lüftungsgitter (LG1,LG2) ausgestaltet, um eine Konvektionskühlung im Inneren des Gehäuses (2) zu ermöglichen,
**dadurch gekennzeichnet, dass**
auf der ersten Leiterplatte (LP1) in unmittelbarer Nähe zu der Oberseite (Ob) ein erster Steckverbinder (S1) angeordnet ist, weiterhin ist auf der Oberseite (Ob) ein lösbarer Adapter (AD) angeordnet, der Adapter (AD) weist einen zweiten Steckverbinder (S2) auf und ist als ein Kodier-Element derart ausgestaltet, dass der Adapter (AD) Zapfen (Z1,...,Z15) aufweist, welche derart angeordnet sind, dass sie bei einem Steckvorgang des zweiten Steckverbinders (S2) in den ersten Steckverbinder (S1) durch Öffnungen des Lüftungsgitters (LG1) passen und somit ein Steckvorgang des zweiten Steckverbinders (S2) in den ersten Steckverbinder (S1) möglich ist, wobei die Zapfen (Z1,...,Z15) derart ausgestaltet sind, dass sie die durch ihre Formgebung exakt in das vorhandene Lüftungsgitter (LG1) passen.

2. Automatisierungsbaugruppe (1) nach Anspruch 1, wobei der erste Steckverbinder (S1) auf der ersten Leiterplatte (LP1) eine Wartungs- und Diagnose-Schnittstelle bildet.

3. Automatisierungsbaugruppe (1) nach Anspruch 1 oder 2, wobei der erste Steckverbinder (S1) mit Teilen der Baugruppe in Verbindung steht, welche für einen sicherheitsrelevanten Gebrauch ausgelegt sind, und der Adapter (AD) mit dem Kodier-Element eine sicherheitsrelevante Kodierung bildet, welcher letztendlich einen Zugriff auf sicherheitsrelevante Betriebsmittel durch ein Kontaktieren der beiden Steckverbinder (S1) zulässt oder durch ein Verhindern einer Kontaktierung der beiden Steckverbinder (S1) den Zugriff nicht zulässt.

4. Automatisierungsbaugruppe (1) nach einem der Ansprüche 1 bis 3, wobei der erste Steckverbinder (S1) als eine Buchse und der zweite Steckverbinder (S2) mit zu beiden Seiten herausragenden Kontaktelementen (KE) ausgestaltet ist.

5. Automatisierungsbaugruppe (1) nach einem der Ansprüche 1 bis 4, wobei im zweiten Steckverbinder (S2) zumindest eine lösbare Kontaktbrücke (K1) angeordnet ist und die Baugruppe ausgestaltet ist eine gesteckte Kontaktbrücke (K1,K2) zu erkennen.

6. Automatisierungsbaugruppe (1) nach einem der Ansprüche 1 bis 5, wobei die Zapfen (Z1,...,Z15) derart ausgestaltet sind, dass durch ihre Länge in Kombination eines Gegenstücks im Inneren des Gehäuses (2) der Adapter (AD) passt oder blockiert wird.

7. Automatisierungsbaugruppe (1) nach Anspruch 4 oder nach einem der Ansprüche 5 oder 6 in Verbindung mit Anspruch 4, wobei der Adapter (AD) einen Kragen (K) um den zweiten Steckverbinder (S2) mit den herausragenden Kontaktelementen (KE) aufweist, und der Kragen (K) mit einer Aussparung (A) für eine Kodierung mit einem Gegenstück ausgestaltet ist.

8. Automatisierungsbaugruppe (1) nach einem der Ansprüche 1 bis 7, wobei der Adapter (AD) eine Lichtquelle als erkennbares Kennzeichen aufweist, welches einen Anlagenbetreiber darauf aufmerksam macht, dass der Adapter (AD) gesteckt ist.

9. Automatisierungsbaugruppe (1) nach einem der Ansprüche 1 bis 8, wobei die Rückseite (Ru) für eine lösbare Montage an einem Baugruppenträger ausgestaltet ist.

## Claims

1. Automation module (1) with a housing (2), wherein the housing (2) has a rear side (Ru),
a front side (Vo),
a lower side (Un),
a top side (Ob),
a left side (li) and
a right side (re),
in the housing (2) a first printed circuit board (LPl) is arranged in parallel between the left side (li) and the right side (re) of the housing (2),
the lower side (Un) and the top side (Ob) are designed at least partially as a ventilation grid (LG1, LG2) in order to enable a convection cooling in the interior of the housing (2),
**characterised in that**
a first plug connector (S1) is arranged on the first printed circuit board (LP1) in the immediate vicinity of the top side (Ob), furthermore a detachable adapter (AD) is arranged on the top side (Ob), the adapter (AD) has a second plug connector (S2) and is designed as an encoding element so that the adapter (AD) has pins (Z1,...,Z15) which are arranged such that during an insertion-withdrawal operation of the second plug connector (S2) into the first plug connector (S1) they pass through openings in the ventilation grid (LG1) and an insertion-withdrawal operation of the second plug connector (S2) into the first plug connector (S1) is therefore possible, wherein the pins (Z1,...,Z15) are designed so that they fit exactly into the available ventilation grid (LG1) as a result of their moulding.

2. Automation module (1) according to claim 1, wherein the first plug connector (S1) forms a maintenance and diagnostics interface on the first printed circuit board (LP1).

3. Automation module (1) according to claim 1 or 2, wherein the first plug connector (S1) is connected to parts of the module which are designed for a safety-relevant use and the adapter (AD) with the encoding element forms a safety-relevant encoding which finally permits access to safety-relevant operating means by contacting both plug connectors (S1) or does not permit the access by preventing the two plug connectors (S1) from making contact.

4. Automation module (1) according to one of claims 1 to 3, wherein the first plug connector (S1) is designed as a socket and the second plug connector (S2) is designed with contact elements (KE) which project toward both sides.

5. Automation module (1) according to one of claims 1 to 4, wherein at least one detachable contact bridge (K1) is arranged in the second plug connector (S2) and the module is designed to identify an inserted contact bridge (K1, K2).

6. Automation module (1) according to one of claims 1 to 5, wherein the pins (Z1,...,Z15) are designed so that the adapter (AD) fits or is blocked in the interior of the housing (2) on account of their length combined with a counterpart.

7. Automation module (1) according to claim 4 or according to one of claims 5 or 6 in conjunction with claim 4, wherein the adapter (AD) has a collar (K) about the second plug connector (S2) with the projecting contact elements (KE), and the collar (K) with a cutout (A) is designed for an encoding with a counterpart.

8. Automation module (1) according to one of claims 1 to 7, wherein the adapter (AD) has a light source as an identifiable indicator, which makes a system operator aware that the adapter (AD) is inserted.

9. Automation module (1) according to one of claims 1 to 8, wherein the rear side (Ru) is designed for a detachable assembly on a module carrier.

## Revendications

1. Module (1) d'automatisation comprenant un boîtier (2), dans lequel le boîtier (2) a une face (Ru) arrière,
une face (Vo) avant,
une face (Un) inférieure,
une face (Ob) supérieure,
une face (li) gauche et
une face (re) droite,
dans le boîtier (2) est monté une première plaquette (LP1) à circuit imprimé, parallèlement entre la face (li) gauche et la face (re) droite du boîtier (2),
la face (Un) inférieure et la face (Ob) supérieure sont conformées au moins en partie sous la forme d'une grille (LG1, LG2) d'aération, afin de permettre un refroidissement par convection à l'intérieur du boîtier (2),
**caractérisé en ce que**
sur la première plaquette (LP1) à circuit imprimé est disposé, à proximité immédiate de la face (Ob) supérieure, un premier connecteur (S1) à enfichage, il est en outre disposé, sur la face (Ob) supérieure, un adapteur (AD) amovible, l'adapteur (AD) a un deuxième connecteur (S2) à enfichage et est conformé en élément de codage, de manière à ce que l'adaptateur (AD) ait des tenons (Z1, ..., Z15), qui sont disposés de manière à ce qu'ils passent, lors d'une opération d'enfichage du deuxième connecteur (S2) à enfichage dans le premier connecteur (S1) à enfichage, par des ouvertures de la grille (LG1) d'aération et rendent ainsi possible un enfichage du deuxième connecteur (S2) à enfichage dans le premier connecteur (S1) à enfichage, dans lequel les tenons (Z1, .., Z15) sont conformés de manière à ce qu'ils passent par leur conformation exactement dans la grille (LG1) d'aération présente.

2. Module (1) d'automatisation suivant la revendication 1, dans lequel le premier connecteur (S1) à enfichage forme, sur la première plaquette (LP1) à circuit imprimé, une interface d'entretien et de diagnostic.

3. Module (1) d'automatisation suivant la revendication 1 ou 2, dans lequel le premier connecteur (S1) à enfichage est en liaison avec des parties du module, qui sont conçues pour un usage pertinent du point de vue de la sécurité, et l'adaptateur (AD) forme, avec l'élément de codage, un codage pertinent pour la sécurité, qui finalement autorise un accès à des moyens de fonctionnement pertinents pour la sécurité par un contact des deux connecteurs (S1) à enfichage ou n'autorise pas l'accès en empêchant une mise en contact des deux connecteurs (S1) à enfichage.

4. Module (1) d'automatisation suivant l'une des revendications 1 à 3, dans lequel le premier connecteur (S1) à enfichage est conformé en douille et le deuxième connecteur (S2) à enfichage est conformé en ayant deux éléments (KE) de contact sortant de deux côtés.

5. Module (1) d'automatisation suivant l'une des revendications 1 à 4, dans lequel, dans le deuxième connecteur (S2) à enfichage, est disposé au moins un pont (K1) de contact amovible et le module est conformé pour identifier un pont (K1, K2) de contact enfiché.

6. Module (1) d'automatisation suivant l'une des revendications 1 à 5, dans lequel les tenons (Z1, ..., Z15) sont conformés de manière à ce que, par sa longueur en combinaison avec une pièce antagoniste à l'intérieur du boîtier (2), l'adaptateur (AD) passe ou soit bloqué.

7. Module (1) d'automatisation suivant la revendication 4 ou l'une des revendications 5 ou 6 en liaison avec la revendication 4, dans lequel l'adaptateur (AD) a un collet (K) autour du deuxième connecteur (S2) à enfichage avec des éléments (KE) de contact en saillie, et le collet (K) est conformé en ayant un évidement (A) pour un codage par une pièce antagoniste.

8. Module (1) d'automatisation suivant l'une des revendications 1 à 7, dans lequel l'adaptateur (AD) a une source lumineuse, comme caractéristique identifiable, qui prévient un utilisateur de l'installation que l'adaptateur (AD) est enfiché.

9. Module (1) d'automatisation suivant l'une des revendications 1 à 8, dans lequel la face (Ru) arrière est conformée pour un montage amovible sur un support de module.
